# EUROPEAN PATENT APPLICATION

(11) **EP 2 797 120 A1**
(43) Date of publication of application: **29.10.2014**
(21) Application number: 12859598.0
(22) Date of filing: 12.12.2012
(51) Int. Cl.: H01L 31/042, F24J 2/46, F24J 2/40, F28G 9/00, G01R 31/28

(54) **DEVICE AND METHOD FOR MEASURING A DROP IN POWER IN A SOLAR PLANT, AND SOLAR PLANT COMPRISING SAID DEVICE**

(30) Priority: 23.12.2011 ES 201132095
(71) Applicant: Abengoa Solar New Technologies, S.A., 41018 Sevilla (ES)
(72) Inventor: MAU, Stefan, E-41018 Sevilla (ES); DELGADO PÉREZ, Álvaro, E-41018 Sevilla (ES)
(74) Representative: Pons Ariño, Angel
(86) International application number: PCT/ES2012/070863
(87) International publication number: WO 2013/093152

(57) **Abstract**

The invention is intended for the accurate, low-cost measurement of a power loss at a solar plant (17) caused by dirt. The device comprises: a first photovoltaic cell (1) for transforming solar energy into a first current (8); cleaning means (4) for cleaning the first cell (1); a second photovoltaic cell (2) for transforming solar energy into a second current (9); a first voltmeter (10) and a second voltmeter (11) for measuring the intensity of the first voltage (8) and the second voltage (9); and a control module (12) for comparing the measurements of the voltmeters (10, 11) and determining the power drop.

## Description

### OBJECT OF THE INVENTION

The present invention can be included within the technical field of solar technology, both for thermal solar and solar photovoltaic technology.

In particular, the invention has the object of a device and a process designed to measure the drop in performance in solar installations. A third object of the invention is a solar installation comprising said device.

### BACKGROUND OF THE INVENTION

To transform solar energy into a type of energy that can be used on a large scale (usually thermal energy or electrical energy), what are called solar thermal or photovoltaic installations (also called plants) respectively, are used.

One of said solar installations comprises in turn one or several (normally several) structures which, in the case of solar thermal installations, are called heliostats. In the case of solar photovoltaic installations, the structures can be fixed or equipped with solar trackers.

The structures are formed by solar collectors which, in the case of solar photovoltaic installations, are called photovoltaic modules which, in turn, comprise a plurality (usually 72) solar devices called photovoltaic cells (also called photoelectric cells). The photovoltaic cells are adapted to collect the solar energy hitting them and generate and electric current from said energy.

Once the configuration or composition of the solar devices comprising the solar installation is decided, the power obtained in said solar installation largely depends on the irradiance hitting the collectors. One of the parameters that largely affect said irradiance is the orientation of the collectors. Another parameter that essentially effects is the dirt accumulated on said collectors, since the accumulation of dust or dirt decreases the useful surface area of the collectors, producing, especially in summer, a considerable drop in performance of the installation, which makes a systematic cleaning of the collectors necessary.

Unfortunately, the effect on the performance of the solar installation of the dirt accumulated on the collectors is not directly quantifiable through a simple visual inspection, so that it is not possible to determine by said inspection if the drop in performance of the solar installation has reached a critical value from which the investment allocated to cleaning of the collectors is lower than the cost associated to the drop in performance.

Therefore, in many solar installations a periodical cleaning is performed of the collectors, which implies the risk of assuming a cost in cleaning when the aforementioned critical value has not yet been reached, or maintaining the solar installation in operation at low performance during a period of time.

There is a very accurate method of determining the drop in performance of a solar installation. Said method comprises performing a measurement of the power obtained associated to dirty photovoltaic modules; cleaning said modules; and taking a power measurement with the clean modules. Later, the two measurements are compared and an estimate is obtained of the degree of dirt of the module. This method has the drawback of being very laborious, for which reason it is rarely used.

The technical problem to be resolved relates to performing, accurately and with low cost, a measurement of the drop of the power generated in a solar installation caused by dirt, to know if the power drop has reached a critical value which makes it advisable to clean said installation.

### DESCRIPTION OF THE INVENTION

The present invention resolves the technical problem posed, through a device for measuring the drop of the power obtained in a solar installation. A second object of the invention relates to a solar installation incorporating said device. A third object of the invention relates to a process for measuring the drop of the power obtained in said solar installation, using said device.

The device of the invention comprises at least one first photovoltaic cell (preferably a plurality of first photovoltaic cells with a size between 4 and 8 inches, i.e. between 10 and 15 cm,) disposed according to a first photovoltaic module que is maintained substantially clean by automated cleaning means, as well as additionally comprising a second photovoltaic cell (preferably a plurality of second photovoltaic cells disposed according to a second photovoltaic module). The disposal of a reduced number (e.g. four) of first photovoltaic cells and/or of second photovoltaic cells makes it possible to obtain a reasonable accuracy in the power measurements made, as shall be explained below, without substantially raising the costs or complexity of the device.

The invention provides the disposal of any automated cleaning means, although, due to its simplicity, a rotating arm (by way, for example, of windscreen wipers) is preferred, in cooperation with nozzles which drive a cleaning solution towards said first cells (preferably water) from a tank, through a pump. Command means are disposed to control the operation of the cleaning means. Said command means are adapted to order the external cleaning of the first cells according to programmable cycles. External cleaning of cells is understood as the cleaning of a transparent protector of glass or plastic that protects the cells.

The solar installation whereto the invention is applicable comprises collectors, adapted to collect the solar radiation and, either transform them into electrical energy or transform them into a heat transfer fluid. The location and conditions, both of the first cells and of the second cells, are representative of the collector operation. The second cells are only possibly cleaned, as shall be explained below. The collectors can be of any type, both of those that are typical of solar thermal installations and solar photovoltaic installations. For example, the collectors can be photovoltaic modules, flat solar collectors, cylindrical-parabolic solar collectors, Fresnel lenses, etc.

Preferably, the first cells are of the same technology as the second cells, understanding as such that the first cells and the second cells are made of identical materials (crystalline silicon, amorphous silicon, CIS, GaAs, etc). Additionally, it is preferred that the first cells are identical to the second cells in the sense that, in the factory, they are adapted to respond in a substantially identical way to the same stimulus. Additionally, it is preferred that the first cells and the second cells are in conditions of life that allow a similar response in identical boundary conditions.

The first and the second photovoltaic cells are connected to respectively different first resistors and second resistors, the values of which are, preferably, sufficiently low to determine an operation of the first cells and the second cells that substantially coincides with the denominated short-circuit point, wherein (given a temperature of the cell and a solar irradiance) the current supplied by the first cells and the second cells has a maximum electric current and a substantially zero voltage. We remind that a I-V curve of a photovoltaic cell represents the pairs (I, V) associated to said cell depending on the resistor connected to the cell, for a determined solar irradiance and cell temperature.

It has a first voltmeter to determine the value of a first voltage drop generated (preferably between 0.4 and 1.5 volts) in the first resistors by the current of the first cells. From the relationship existing between the I-V curves of a same cell for different irradiances and temperatures, it is known that the short-circuit point current (obtained from the voltage according to the corresponding I-V curve) is a value highly representative of the power generated by the cell, since it relates to substantially proportional magnitudes.

It also has a second voltmeter to determine the value of a second voltage drop generated (preferably between 0.4 and 1.5 volts) in the second resistors by the current of the second cells, in similar manner and with the same base as that explained previously for the first cells.

The invention additionally comprises a control module adapted to receive the measurements of the first and the second voltage drops mentioned above, as well as comprising calculation means to compare the values of the first voltage and the second voltage and, from said comparison, determine the power drop, caused by the effect of dirt, in the solar installation collectors, based on known relationships or obtained from among the operations of the first cells, the second cells and the collectors.

Since, as indicated above, the second cells are representative, in terms of the degree of dirt and working conditions (such as irradiance) of the solar installation collectors, said relationships make it possible to estimate with great reliability the performance of the solar installation.

The invention is adapted to determine the drop of power of any solar installation designed for the transformation of solar energy, both photovoltaic and thermal solar. Likewise, the first cells and the second cells will be located in a location that makes it reasonably possible to assume that the conditions of dirt, irradiance, orientation, wind, temperature, etc. of said first cells and second cells are substantially the same as those of the solar installation collectors they represent.

### DESCRIPTION OF THE DRAWINGS

To complement the description being made and in order to aid towards a better understanding of the characteristics of the invention, in accordance with a preferred example of practical embodiment thereof, a set of drawings is attached as an integral part of said description wherein, with illustrative and non-limiting character, the following has been represented:

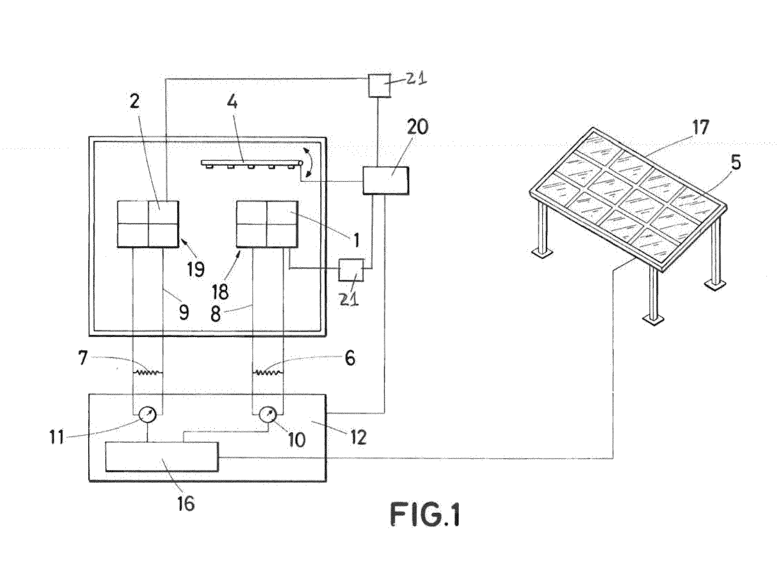

Figure 1.- Shows a schematic view of the device of the invention.

### PREFERRED EMBODIMENT OF THE INVENTION

Below, with the aid of figure 1 attached, the description is given of a preferred embodiment of the installation for measuring the drop of power in a solar photovoltaic installation (17) according to the present invention.

Through the description of the preferred embodiment, the following numerical references shall be used referring to the elements indicated:
1.- First cells
2.- Second cells
4.- Cleaning rotating arm (cleaning means)
5.- Collectors of the controlled installation
6.- First resistor
7.- Second resistor
8.- First current
9.- Second current
10.- First voltmeter
11.- Second voltmeter
12.- Control module
16.- Calculation means
17.- Solar installation controlled with the device of the invention
18.- First module (comprising the first cells)
19.- Second module (comprising the second cells)
20.- Command means of the cleaning means
21.- Measurement means for measuring the radiant energy collected by the first cells and the second cells.

Dirt affects the solar radiation that reaches the photovoltaic cells of a photovoltaic module. The best way of quantifying the effect of dirt on module performance is to measure the electric current of current generated by said module. In order to not introduce errors arising from changes in the module temperature and/or in the intesity of the radiation, the most reliable thing is to base the measurement on a comparison of a clean module with a dirty module.

Therefore, the device of the invention comprises a first solar photovoltaic module (18), incorporating a plurality of first photovoltaic cells (1) connected in series, and a second solar photovoltaic module (19), incorporating a plurality of second photovoltaic cells (2) connected in series.

A suitable number of cells connected in series is preferably such that they can be cleaned easily and safety with a cleaning means such as those that will be described below. A high number of cells corresponds to a larger area and thus more representative for the collectors installed in the installation. The first cells (1) are maintained externally clean by automated means comprising nozzles (not shown) which drive a cleaning solution (preferably water) from a tank (not shown) towards the first cells (1) through a pump (not shown), as well as a rotating arm (4) (by way of windscreen wiper) to remove the dirt from the first cell (1) together with the cleaning solution. The first cells (1) are identical to the second cells (2). Command means (20) control the operation of the cleaning means, actuating the pump and the arm (4) according to programmable cycles.

The solar photovoltaic installation (17) whereto the invention is applied, comprises collectors (5), where the orientation, the temperature and wind conditions to which the second cells (2) are exposed are substantially identical to that of the collectors (5). In this way, it is achieved that the second cells (2) are representative of the collectors (5). The first cells (1) and the second cells (2) are of the same technology, manufacturer, type and size.

The automated external cleaning of the first cells (1) is performed with a periodicity that depends on the location and particular conditions of the solar installation (17). Depending on the case, it will be sufficient to perform a daily cleaning first think in the morning or several cleanings throughout the day shall be necessary.

The first cells (1) and the second cells (2) are respectively connected to a first resistor (6) and to a second resistor (7) of sufficiently low values (preferably the same) so that a first current (8) and a second current (9) produced respectively by said first cells (1) and second cells (2) has a first electric current and a second electric current close to that of short-circuit, as well as a substantially zero first voltage and second voltage.

By way of example, the first resistor (6) and the second resistor (7) can have values around 10 mΩ.

A first voltmeter (10), connected to the first cells (1) and to the first resistor (6), serves for periodically measuring the value of the first voltage. Similarly, a second voltmeter (11), connected to the second cells (2) and to the second resistor (7), serves for periodically measuring the value of the second voltage. Given that the cells used will give a current in the range of 4 to 15 amps approximately, and assuming that a resistor of 0.01 ohms shall be used, the first voltage and the second voltage shall be approximately between 0.4 and 1.5 volts.

The device additionally incorporates a control module (12), connected to a power source (not shown), to periodically receive the measurements made by the first voltmeter (10) and by the second voltmeter (11). In calculation means (16), also belonging to the control module (12), a comparison is established between the first voltage and the second voltage and, from said comparison, the percentage of power loss of the solar installation (17) produced caused by dirt is estimated.

A first estimate of the power loss can be obtained from the quotient C of the second voltage between the first voltage, in particular, the value in decimals of said power loss would be 1 - C with an acceptable precision.

When the value of the power loss estimated in the solar installation (17) reaches a previously established threshold, the control unit (12) indicates the need for cleaning the collectors (5), and said control unit emits a message so that the second cells (2) are also cleaned. A maintenance team is usually responsible for cleaning the collectors (5) and the second cells (2).

The possibility is contemplated that the solar installation (17) is a photovoltaic installation, so that the collectors (5) would comprise third photovoltaic cells (5). Likewise, the third cells (5) would preferably be identical (in the sense explained above) to the first cells (1) and the second cells (2).

The control module (12) can preferably be in the form of a PLC (12) comprising both elements (hardware) and instructions (software) adapted to receive the values of the first voltage and the second voltage, execute the necessary calculations and comparisons and, where applicable, return the calculated values and the appropriate signals of cleaning or not cleaning. Likewise, preferably, the first voltmeter (10), the second voltmeter (11) and, optionally the command means (20) are incorporated in the PLC (12).

After heavy rain or after said cleaning of the collectors (5) and the second cells (2), the deviation can be calibrated between the first cells (1) and the second cells (2), given that both would give the same signal when they are clean, if they are identical cells (1, 2). If they do not substantially give the same signal, it can be a symptom of an anomaly in the cells (1, 2), which must be considered and acted on in consequence. Just after cleaning the relationship between the signals must also be the same, e.g. the first cell gives 4.2 A at 1000 W/m² and the second cell gives 4.1 A at 1000 W/m². If this relationship changes, it is a symptom that there is a problem.

The advantages of this method are that the signal measured very precisely quantifies, taking into account the simplicity of the device used, the losses due to dirt in a solar installation. Furthermore, it is possible to access the data of the remote control measurements through an Internet connection. The equipment maintenance is minimum since the possible faults are easily detected by comparing the two signals after rain or cleaning. In this way, it is not necessary to establish an exhaustive scheduled preventive maintenance, since the comparison of the real relationship between the two signals with the relationship they should have in conditions of correct operation allows a possible fault to be anticipated and acted on in consequence.

With the aim of giving the estimate of the power loss even greater precision, the following additional process is proposed:
- performing a cleaning of the second cells (2) and the collectors (5);
- performing the following actions during a number to be determined of consecutive times (e.g. thirty days) following the cleaning:
   a) determining the energy production of the plant, P, e.g. reading said production from a recorder or meter associated to the plant; and
   b) using measurement means (21) of the radiation, connected to the first cells (1) and to the second cells (2), determining the total radiant energy G₁ and G₂, respectively, collected by said first cells (1) and second cells (2), with the optional additional condition that for calculation of G₁ and G₂ it only takes into consideration the time intervals where the irradiance that hits the first cells (1) and the second cells (2) is greater than a certain threshold value that allows a reasonable transformation of the energy associated to said irradiance;
- determining, from the data previously obtained for G₁, G₂ and P, from each period (e.g. from each day), the coefficients A and B in the regression curve Y = A*X + B, where:
   X represents G₂/G₁, and
   Y represents P/G₁.

Optionally, it is possible to additionally perform a graphic representation of the values G₁, G₂ and of the linear regression curve Y = A*X +B.

For each pair of measurements of first voltage and second voltage, the calculation means (16) of the control module (12) shall calculate, from coefficients A and B, the corresponding value Y for a value X equal to quotient C between the first voltage and the second voltage. From the value Y, the control module shall return an estimate of the power loss in decimals equal to 1 - Y, which is more accurate than the previously proposed estimate 1-C.

## Claims

1. Device for measuring the drop of power in a solar installation (17), **characterized in that** it comprises:
- at least one first photovoltaic cell (1) connected to a first resistor (6), said first cell (1) adapted to collect solar energy and transform said solar energy into a first electric current (8);
- cleaning means (4) automated to maintain the first cell (1) clean;
- at least one second photovoltaic cell (2) connected to a second resistor (7), said second cell (2) adapted to collect solar energy and transform said solar energy into a second electric current (9), where said first cell (1) and second cell (2) are representative of the operating conditions of a plurality of collectors (5) forming the solar installation (17);
- first resistors (6) and second resistors (7) respectively connected to the first cells (1) and the second cells (2);
- a first voltmeter (10) and a second voltmeter (11) to respectively determine the value of a first voltage drop generated in the first resistor (6) by the first current (8), and a second voltage drop generated in the second resistor (7) by the second current (9); and
- a control module (12) to receive the measurements from the first voltmeter (10) and from the second voltmeter (11),
where the control module (12) additionally comprises:
- calculation means (16) for establishing a comparison of values of the first voltage with values of the second voltage and, from said comparison, determining a power loss in the solar devices (5) of the solar installation (17) caused by dirt, based on known relationships or relationships obtained from the operation of said solar devices (5) and the second cell (2).

2. Device for measuring the drop of power in solar energy transformation installations, according to claim 1, wherein the values of the first resistor (6) and/or of the second resistor (7) are sufficiently low so that the intensities of the first current (8) and of the second current (9) are substantially equal to the short-circuit electric currents of the I-V curve of, respectively, the first cells (1) and the second cells (2), for a temperature of the first cells (1) and of the second cells (2), as well as for a solar irradiance, given.

3. Device for measuring the drop of power in solar energy transformation installations, according to claim 1, wherein there exists a plurality of first photovoltaic cells (1) grouped according to a first solar photovoltaic module (18), as well as a plurality of second photovoltaic cells (2) grouped according to a second solar photovoltaic module (19).

4. Device for measuring the drop of power in solar energy transformation installations, according to any of claims 1 and 3, wherein the first cells (1) are identical to the second cells (2).

5. Device for measuring the drop of power in solar energy transformation installations, according to claim 1, wherein the cleaning means comprise:
- at least one nozzle to drive (1) a cleaning solution from a tank towards the first cell through a pump;
- a rotating arm (4) to remove the dirt from the first cell (1) together with the cleaning solution; and
- command means adapted to determine the operation of the pump and of the arm (4) according to programmable cycles.

6. Device for measuring the drop of power in solar energy transformation installations, according to claim 1, wherein the control means (12) incorporate the first voltmeter (10) and the second voltmeter (11).

7. Solar installation (17), comprising collectors (5) adapted to collect and transform solar energy, additionally comprising the device described in any of claims 1 to 6.

8. Solar installation (17), according to claim 7, wherein the collectors (5) are third photovoltaic cells (5).

9. Solar installation (17), according to claim 8, wherein the third cells (5) are identical to the first cells (1) and/or to the second cells (2).

10. Solar installation (17), according to any of claims 7 to 9, wherein the first cells (1) and the second cells (2) are located in a environment with substantially the same conditions of at least dirt, temperature, irradiance, orientation, wind, as the collectors (5), to be representative of said collectors (5).

11. Process for measuring the drop of power in the solar installation described in any of claims 7 to 10 using the device described in claims 1 to 6, comprising the following stages:
- measuring with the first voltmeter (10) the first voltage (8) generated by the first photovoltaic cell (1) connected to the first resistor (6);
- measuring with the second voltmeter (11) the second voltage (9) generated by the second photovoltaic cell (2) connected to the second resistor (7);
- receiving in the control module (12) the measurements made by the first voltmeter (10) and the second voltmeter (11);
- establishing a comparison, using the calculation means (16), of the values of the voltage measured by the first voltmeter (10) with the voltage measured by the second voltmeter (11); and,
- determining, from said comparison, the drop of power in the second collectors (5), based on known relationships or obtained from among the operation of the second cells (2) and the collectors (5) of the solar installation (17).

12. Process according to claim 11, comprising the following prior stages:
- cleaning the second cells (2) and the collectors (5);
- performing the following actions during a number of consecutive time periods (e.g. thirty days) following the cleaning:
a) determining the energy production of the plant, P, and
b) using measurement means (21) of the radiation, connected to the first cells (1) and to the second cells (2), determining the total radiant energy G₁ and G₂, respectively, collected by the first cells (1) and the second cells (2);
- determining, from the data previously obtained for G₁, G₂ and P, of each period, the coefficients A and B in the regression curve Y = A*X + B, where:
X represents G₂/G₁, and
Y represents P/G₁.
where for each pair of measurements of first voltage and second voltage, the calculation means (16) of the control module (12) calculate, from the coefficients A and B, the corresponding value Y for a value X equal to the quotient C among the first voltage and the second voltage, and, from the value Y, the control module (12) returns an estimate of the power loss which, in decimals, is equal to 1 - Y.

13. Process according to any of claims 11 and 12, wherein, after the determination of the drop of power, it additionally comprises the following steps:
- comparing, using the calculation means (16), the value of the drop of power with a pre-established threshold value;
- determining, by means of the control means (12), the cleaning of the second collectors (5) if the value of the drop of power is greater than said threshold value.

14. Process according to claim 13, comprising the periodical repetition of the steps described.

15. Process according to any of claims 12 to 14, additionally comprising the step of maintaining the first cells (1) clean by means of the action of the cleaning means according to a programmable cycle.
